# EUROPEAN PATENT APPLICATION

(11) **EP 2 500 626 A2**
(43) Date of publication of application: **19.09.2012**
(21) Application number: 12158790.1
(22) Date of filing: 09.03.2012
(51) Int. Cl.: F21S 8/02, F21V 19/00

(54) **LED engine for illumination**

(30) Priority: 14.03.2011 KR 20110022553; 15.02.2012 KR 20120015538
(71) Applicant: Samsung LED Co., Ltd., Gyeonggi-do 443-743 (KR)
(72) Inventor: Koo, Won-hoe, Seoul (KR); Woo, Yun-seok, Gyeonggi-do (KR); Lim, Dong-il, Gyeonggi-do (KR); Han, Deok-hee, Seoul (KR); Park, Chul, Seoul (KR); Lee, Il-seok, Seoul (KR)
(74) Representative: Grünecker, Kinkeldey, Stockmair & Schwanhäusser

(57) **Abstract**

A light-emitting device (LED) engine (100) includes: a body (110) having a through-hole; a light-emitting module (130) that is disposed under the body, includes at least one light emitting device (C), and is disposed to expose a light-emitting surface via the through-hole; and a printed circuit board (120)(PCB) which is disposed under the body, to which the light-emitting module (130) is coupled, and includes a terminal unit for supplying power to the light-emitting module (130).

## Description

### BACKGROUND

### 1. Field

The present disclosure relates to light-emitting devices (LED) engines for illumination.

### 1. 2. Description of the Related Art

Light-emitting devices (LED) refer to semiconductor devices that generate various light colors by constituting a light source via a PN junction of a compound semiconductor. Recently, blue LEDs and ultraviolet ray LEDs using nitrides that have excellent physical and chemical characteristics have been developed and also, the combination of the blue or ultraviolet ray LEDs with a fluorescent material enables the generation of white light or other mono-color light, thereby widening the application range of LEDs. LEDs have long lifetimes, are manufactured as small and lightweight devices, have a strong directivity property of light to enable driving at low voltage, are strongly resistant to impact and vibration, do not require a preheating time and complicated driving, and are able to be packaged in various shapes. Due to these features, they are applicable for various purposes.

Recently, LEDs are used as, in addition to a backlight of a display device, a high-output and highly efficient light source that is included in various illumination devices including general illuminations, decorative illuminations, and spot illuminations. Also, LEDs are used as an engine that is coupled to an illumination set and is replaceable. In this case, there is a need to develop a body structure that allows an LED to be easily coupled to the illumination set, with improvement in the efficiency of an LED package and light quality, such as output.

### SUMMARY

Provided are light-emitting devices (LED) engines for illumination with good light quality.

Additional aspects will be set forth in part in the description which follows and, in part, will be apparent from the description, or may be learned by practice of the presented embodiments.

According to an aspect of the present invention, a light-emitting device (LED) engine includes: a body having a through-hole; a light-emitting module that is disposed under the body, includes at least one light emitting device, and is disposed to expose a light-emitting surface via the through-hole; and a printed circuit board (PCB) which is disposed under the body, to which the light-emitting module is coupled, and includes a terminal unit for supplying power to the light-emitting module.

The through-hole may be formed in a central portion of the body and has a circular cross-sectional shape having a predetermined diameter. The body may have a flat surface that enters in a direction from a top surface of the body to the through-hole and surrounds the through-hole.

The light-emitting module may be electrically connected to the terminal unit via a conductive rubber.

At least one thermally conductive pad may be disposed under the PCB.

The LED engine may further include a diffusion unit that is disposed above the light-emitting module and mixes light emitted from the light-emitting module.

The LED engine may further include a light distribution controller that is disposed above the light-emitting module and includes at least one lens portion respectively corresponding to the at least one light emitting device of the light-emitting module.

The diffusion unit may be formed as a diffusion sheet, which is spaced apart from the light-emitting module by a predetermined distance, and the diffusion sheet may be placed on the flat surface.

At least one surface of the diffusion sheet may have a micro pattern.

The diffusion sheet may include a diffusing material and a resin material filled with a fluorescent material.

The diffusion unit may be formed by filling a mixture including a resin material and a diffusing material up to a predetermined height of the through-hole to cover the light-emitting module, and the mixture may further include a fluorescent material.

A plurality of protruding portions may be formed on a lower surface of the body and a plurality of holes are formed in the PCB, respectively corresponding to the protruding portions, wherein the body is press-in coupled to the PCB substrate.

The LED engine may further include a plurality of bosses for coupling with an external device on an outer wall of the body, and a plurality of coupling holes for coupling with an external device may be formed in an upper surface of the body.

The light-emitting module may include a substrate and the at least one light emitting device disposed on the substrate, and a connection portion for connecting the at least one light emitting device in series, parallel, or a combination thereof, wherein the connection portion is formed as a metal layer covering a portion of each of the light emitting devices, a portion of the substrate, and a portion of a corresponding adjacent light emitting device.

An uneven structure may be formed on a portion of the substrate on which the metal layer is not formed, and the uneven structure may have an indented portion having a slanted side surface.

Alternatively, the light-emitting module may include a substrate and a plurality of light emitting devices disposed on the substrate, and a connection portion that connects the plurality of light emitting devices in series, parallel, or a combination thereof and is formed as a metal layer covering a portion of each of the plurality of light emitting devices, a portion of the substrate, and a portion of a corresponding adjacent light emitting device, wherein each of the light emitting devices includes an active layer that emits blue light, and the plurality of light emitting devices include a light emitting device including a red light conversion portion having a red light-converting material and a light emitting device including a green light conversion portion having a green light-converting material.

Some of the plurality of light emitting devices may include a light emitting device that do not include neither the green light conversion portion nor the red light conversion portion.

The green light conversion portion or the red light conversion portion may be shared by two or more adjacent light emitting devices.

### BRIEF DESCRIPTION OF THE DRAWINGS

These and/or other aspects will become apparent and more readily appreciated from the following description of the embodiments, taken in conjunction with the accompanying drawings in which:

FIG. 1 is a perspective schematic outer view of a light-emitting device (LED) engine according to an embodiment of the present invention;

FIG. 2 is a perspective detailed cut view of a portion of the LED engine of FIG. 1;

FIG. 3 is an exploded perspective view of the LED engine of FIG. 1 to explain a coupling structure;

FIG. 4 is an exploded perspective view of a lower surface of a body of the LED engine of FIG. 3 to explain press-in coupling between the body and a PCB;

FIG. 5 is a cross-sectional view of the LED engine of FIG. 1;

FIG. 6 is a perspective view of a light distribution controller that may be additionally included in the LED engine of FIG. 1;

FIG. 7 is a cross-sectional view of a light-emitting device that is employable in a light-emitting module of the LED engine of FIG. 1;

FIG. 8 is a cross-sectional view of an example of a light emitting device that is employable in a light-emitting module of the LED engine of FIG. 1;

FIG. 9 is a cross-sectional view of another example of a light emitting device that is employable in the light-emitting module of the LED engine of FIG. 1;

FIG. 10 is a cross-sectional view of another example of a light emitting device that is employable in the light-emitting module of the LED engine of FIG. 1;

FIG. 11 is a plan view of an example of a light-emitting module that may be employable in the LED engine of FIG. 1;

FIGS. 12A and 12B are cross-sectional views of the light-emitting module of FIG. 10 taken along lines A1-A1' and B1-B1', respectively;

FIG. 13 is a plan view of another example of the light-emitting module that may be employable in the LED engine of FIG. 1;

FIG. 14 is a cross-sectional view of the light-emitting module of FIG. 13 taken along a line A1-A1';

FIG. 15 is a cross-sectional view of a modified example of the light-emitting module of FIG. 13;

FIG. 16 is a cross-sectional view of another modified example of the light-emitting module of FIG. 13;

FIG. 17 is a plan view of a modified example of the body of the LED engine of FIG. 1;

FIG. 18 illustrates an example of boss coupling of the body of FIG. 17 and an external device;

FIG. 19 illustrates an example of screw coupling of the body of FIG. 17 and an external device;

FIG. 20 is a schematic cross-sectional view of an LED engine according to another embodiment of the present invention;

FIG. 21 is a schematic cross-sectional view of an LED engine according to another embodiment of the present invention;

FIG. 22 is an exploded schematic view of an LED engine according to another embodiment of the present invention; and

FIG. 23 is an exploded schematic view of an LED engine according to another embodiment of the present invention.

### DETAILED DESCRIPTION

Reference will now be made in detail to embodiments, examples of which are illustrated in the accompanying drawings, wherein like reference numerals refer to like elements throughout and sizes or thicknesses of the elements may be exaggerated for clarity. In this regard, the present embodiments may have different forms and should not be construed as being limited to the descriptions set forth herein. Accordingly, the embodiments are merely described below, by referring to the figures, to explain aspects of the present description. Expressions such as "at least one of," when preceding a list of elements, modify the entire list of elements and do not modify the individual elements of the list.

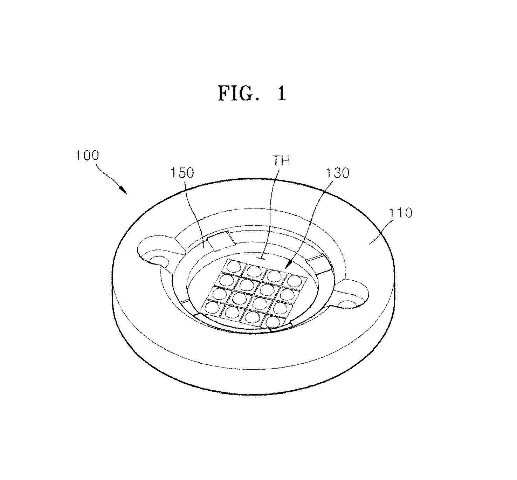

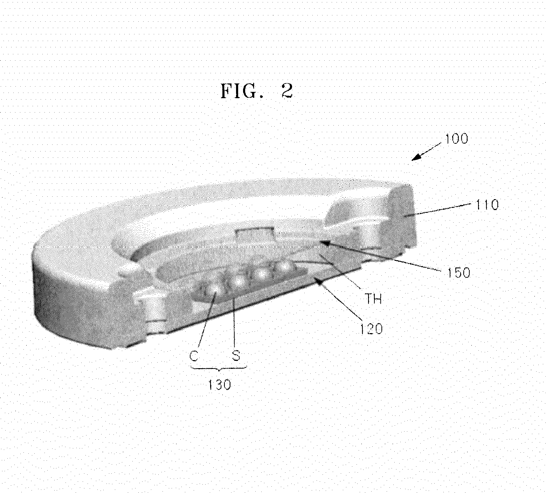

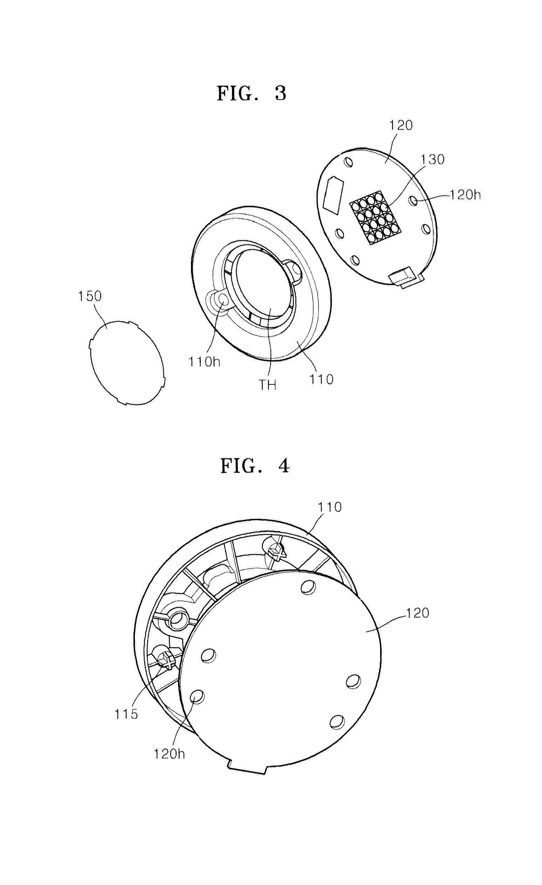

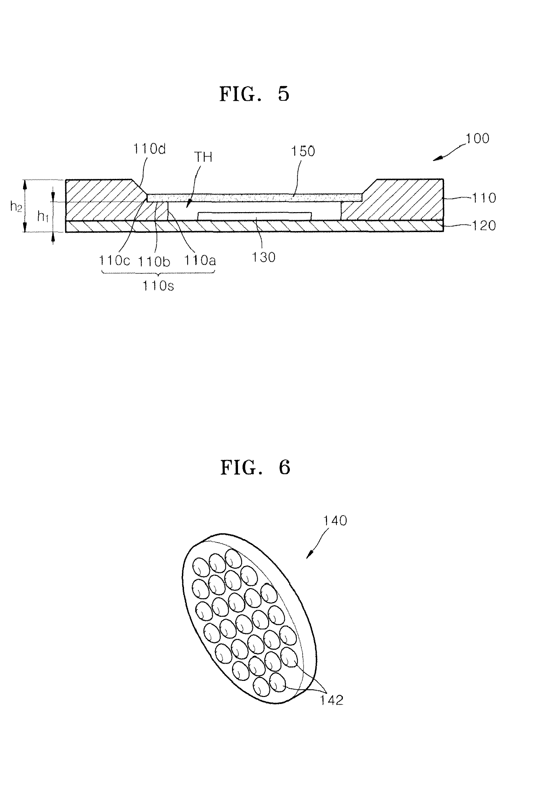

.FIG. 1 is a perspective schematic outer view of a light-emitting device (LED) engine 100 according to an embodiment of the present invention, FIG. 2 is a perspective detailed cut view of a portion of the LED engine 100 of FIG. 1, FIG. 3 is an exploded perspective view of the LED engine 100 of FIG. 1 to explain a coupling structure, FIG. 4 is an exploded perspective view of a lower surface of a body 110 of the LED engine 100 of FIG. 3 to explain press-in coupling between the body 110 and a printed circuit board (PCB) 120, and FIG. 5 is a cross-sectional view of the LED engine 100 of FIG. 1.

Referring to FIGS. 1 to 5, the LED engine 100 includes the body 110 having a through-hole TH in which are disposed a light emitting module 130 and a diffusion unit 150 that is disposed above the light-emitting module 130 and mixes light emitted from the light-emitting module 130. The light emitting module 130 includes a substrate S and at least one light emitting device C disposed on the substrate S.

The LED engine 100 according to the present embodiment may be used for illumination purposes, and for example, may be used as an engine for spot illuminations. The LED engine 100 has a structure that is easily employable in various illumination devices.

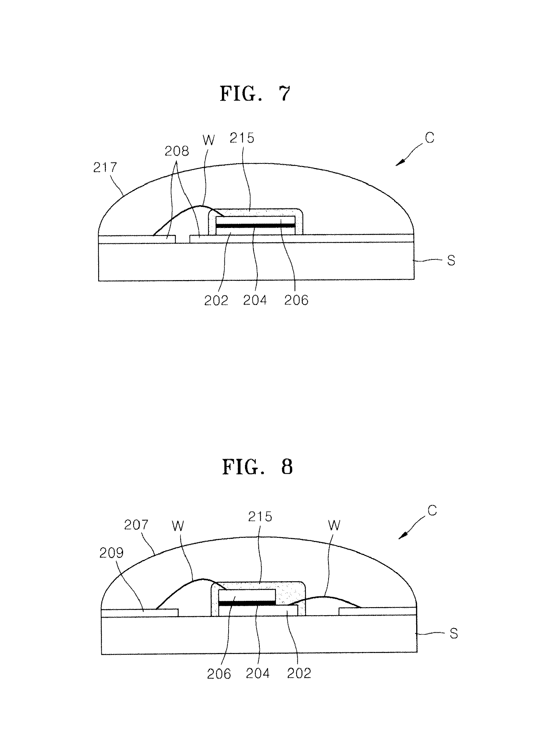

The light-emitting module 130 may include one or more light emitting devices C. Although the illustrated light-emitting module 130 includes a plurality of light emitting devices C, if only one light emitting device C is enough to emit a desired intensity of light, the light-emitting module 130 may include only one light emitting device C. A light emitting device C includes a first type semiconductor layer, an active layer, and a second type semiconductor layer, and when a voltage is applied thereto, electrons and holes are recombined in the active layer, thereby emitting light, as described in detail below with reference to FIGS. 7 to 16.

The body 110 forms an outer shape of the LED engine 100 and also, allows the light-emitting module 130 to be installed therein. The shape of the body 110 is not limited to the illustrated shape, and for example, may vary according to requirements of an illumination set.
[0001] The LED engine 100 may further include the printed circuit board (PCB) 120 disposed on the lower surface of the body 110, forming a lower surface of the through-hole TH, and the light-emitting module 130 may be coupled to the PCB 120. For example, a terminal unit (not shown) for supplying power to the light-emitting module 130 may be disposed on the PCB 120, and an electrode pad of the light-emitting module 130 may be electrically connected to the terminal unit of the PCB 120

The through-hole TH of the body 110 may have, as illustrated, a circular cross-sectional shape having a predetermined diameter. However, the shape of the through-hole TH is not limited thereto.

The body 110 may have a flat surface 110c that enters in a direction from a top surface 110a of the body 110 to the through-hole TH and surrounds the through-hole TH. A top surface 110a and the flat surface 110c may be, as illustrated, connected via a slanted surface 110b. The diffusion unit 150 may have a sheet shape and may be placed on the flat surface 110c.

As illustrated in FIGS. 3 and 4, a hole 110h for, for example, screw-coupling may be formed in opposite sides of a top surface of the body 110 and a protruding portion 115 for press-in coupling may be formed on the lower surface of the body 110. The PCB 120 has a plurality of holes 120h for coupling with the body 110 and thus, the PCB 120, to which the light-emitting module 130 is attached, is coupled with the body 110 using the holes 120h. However, the illustrated coupling method is just an example and various other coupling methods may also be used.

The diffusion unit 150 diffuses and mixes light emitted from the light-emitting module 130 and emits the light with a reduced artifact interference phenomenon that may occur due to the arrangement shape of the light emitting devices C constituting the light-emitting module 130. The diffusion unit 150, as illustrated, may be a diffusion sheet spaced apart from the light-emitting module 130 by a predetermined distance. As a material for forming the diffusion unit 150, a transparent plastic based on poly carbonate (PC), poly methyl methacrylate acrylic (PMMA), or the like, glass, or a semitransparent plastic may be used. Also, these transparent materials may be mixed with a diffusion material for use as the diffusion unit 150. Also, a fluorescent material may be further added to the material that forms the diffusion unit 150 to change colors of light emitted from the light-emitting module 130.

The diffusion sheet-shaped diffusion unit 150 may be placed on the flat surface 110b of the step surface 110s. A height h1 between the lower surface of the PCB 120 and the flat surface 110b may be equal to or greater than about 3.5 mm and equal to or less than 4 mm. Alternatively, a height ratio of h1/h2 may be in a range of about 12/25 to about 1, wherein h1 is the distance from the lower surface of the PCB 120 to the flat surface 110b where the diffusion unit 150 is placed and h2 is a distance between the lower surface of the PCB 120 to the top surface of the body 110. Regarding emission of light with uniform distribution after light emitted from the light-emitting module 130 is mixed, the location of the diffusion unit 150 is appropriately determined to strike a balance between light efficiency and light diffusion effect. The more the diffusion sheet is disposed adjacent to the light-emitting module 130, the higher diffusion effect may be obtainable. However, light efficiency may decrease.

A thickness of the diffusion sheet may be in a range of about 0.8 mm to about 1.5 mm.
The diffusion sheet may have a micropattern (not shown) on at least one surface thereof. The micropattern formed at one or opposite surfaces of the diffusion sheet may diffuse light to reduce an artifact interference phenomenon that may occurs due to the array of the light-emitting device C, and in this case, the diffusion sheet may be formed of either a transparent material that is not mixed with a diffusing material, or a mixture including the transparent material and the diffusing material.

As described above, due to the inclusion of the diffusion unit 150, the illusion light emitted from the LED engine 100 may overall have a uniform distribution. That is, the LED engine 100 has a reduced artifact interference phenomenon and thus has a more smooth light distribution, thereby providing pleasant illumination light that induces less eye fatigue.

FIG. 6 is a perspective view of a light distribution controller 140 that may be additionally included in the LED engine 100 of FIG. 1. The light distribution controller 140 may be further disposed on the light-emitting module 130. The light distribution controller 140 may include at least one lens portion 142 corresponding to the at least one light emitting device C of the light-emitting module 130, thereby enabling control of a directional angle of light emitted from each of the light emitting devices C of the light-emitting module 130.

FIG. 7 is a cross-sectional view of an example of a light emitting device C that is included in the light-emitting module 130 of the LED engine 100 of FIG. 1.

The light emitting device C includes a light-emitting chip including a first type semiconductor layer 202, an active layer 204, and a second type semiconductor layer 206 all disposed on the substrate S, and a fluorescent layer 215 applied surrounding the light-emitting chip .

The substrate S may be a resin substrate, for example, an FR4 or FR5 substrate. Alternatively, the substrate S may instead be formed of a ceramic or a glass fiber.

Each of the first type semiconductor layer 202, the active layer 204, and the second type semiconductor layer 206 may include a compound semiconductor. For example, each of the first type semiconductor layer 202 and the second type semiconductor layer 206 may include a nitride semiconductor, for example, AIxInyGa(1-x-y)N (0≤x≤1 , 0≤y≤1, and 0≤x+y≤1) and the first type semiconductor layer 202 and the second type semiconductor layer 206 may be respectively doped with an n-type impurity and a p-type impurity. The active layer 204 formed between the first and second type semiconductor layers 202 and 206 may emit light having a predetermined energy level due to the recombination of electrons and holes, and the active layer 204 may have a multi-layered structure including a plurality of layers each including InxGa1-xN (0≤x≤1) to control energy of a band gap according to Indium content, In this case, the active layer 204 may have a multi quantum well (MQW) structure in which a quantum barrier layer and a quantum well layer are alternately stacked, and for example, the active layer 204 may have an InGaN/GaN structure, the indium content thereof may be controlled to emit blue light.

The fluorescent layer 215 may include a fluorescent material that absorbs blue light and emits red light and a fluorescent material that absorbs blue light and emits green light. Examples of the fluorescent material that emits red light are a nitride-based fluorescent material represented by MAISiNx:Re (1≤x≤5) and a sulfide-based fluorescent material represented by MD:Re, wherein M includes at least one selected from the group consisting of barium (Ba), strontium (Sr), calcium (Ca), and magnesium (Mg), D includes at least one selected from the group consisting of sulfur (S), selenium (Se), and tellurium (Te), and Re includes at least one selected from the group consisting of europium (Eu), yttrium (Y), lanthanum (La), cerium (Ce), neodymium (Nd) promethium (Pm), samarium (Sm), gadolinium (Gd), terbium (Tb), dysprosium (Dy), holmium (Ho), erbium (Er), thulium (Tm), ytterbium (Yb), lutetium (Lu), fluorine (F), chlorine (Cl), bromine (Br), and iodine (I). Also, examples of the fluorescent material that emits green light are a silicate-based fluorescent material represented by M2Si04:Re, a sulfide-based fluorescent material represented by MA2D4:Re, a fluorescent material represented by β-SiAlON:Re, and an oxide-based fluorescent material represented by MA'2O4:Re', wherein M includes at least one selected from the group consisting of barium (Ba), strontium (Sr), calcium (Ca), and magnesium (Mg), A includes at least one selected from the group consisting of gallium (Ga), aluminum (Al), and indium (In), D includes at least one selected from the group consisting of sulfur (S), selenium (Se), and tellurium (Te), A' includes at least one selected from the group consisting of scandium (Sc), yttrium (Y), gadolinium (Gd), lanthanum (La), lutetium (Lu), aluminum (Al), and indium (In), Re includes at least one selected from the group consisting of europium (Eu), yttrium (Y), lanthanum (La), cerium (Ce), neodymium (Nd) promethium (Pm), samarium (Sm), gadolinium (Gd), terbium (Tb), dysprosium (Dy), holmium (Ho), erbium (Er), thulium (Tm), ytterbium (Yb), lutetium (Lu), fluorine (F), chlorine (Cl), bromine (Br), and iodine (I), and Re' includes at least one selected from the group consisting of cerium (Ce), neodymium (Nd), promethium (Pm), samarium (Sm), terbium (Tb), dysprosium (Dy), holmium (Ho), erbium (Er), thulium (Tm), ytterbium (Yb), fluorine (F), chlorine (Cl), bromine (Br), and iodine (I). Some of the blue light emitted from the active layer 204 is converted into red light and the remaining blue light is converted into green light, and thus blue light, red light, and green light are mixed to emit white light.

The fluorescent layer 215 may include a yellow florescent material. An example of the yellow fluorescent material is a yttrium aluminum garnet (YAG) fluorescent material. In this case, some of blue light emitted from the active layer 204 are converted into yellow light, and due to a combination of blue light and yellow light, white light is generated.

An electrode pattern 208 that includes two separate portions is disposed on the substrate S. The electrode pattern 208 may be formed by, for example, plating, for example, a conductive material, such as Cu, Pd, Ag, or Ni/Au. The first type semiconductor layer 202 may contact one portion of the electrode pattern 208 and the second type semiconductor layer 206 may contact the other portion of the electrode pattern 208 using a wire W.

Also, a cover layer 217 may be further formed on the substrate S in a lens shape to protect the light-emitting chip and control a direction property of light emitted from the light-emitting chip. The cover layer 217 may be formed of a transparent material, such as resin. The shape of the cover layer 217 is not limited to the illustrated lens shape and may instead be flat only to protect the light-emitting chip without functioning as a lens.

FIG. 8 is a cross-sectional view of another example of a light emitting device C that is included in the light-emitting module 130 of the LED engine 100 of FIG. 1. The light emitting device C according to the present embodiment is different from the light emitting device C described with reference to FIG. 8 in terms of an electrode structure. That is, the light-emitting chip including the first type semiconductor layer 202, the active layer 204, and the second type semiconductor layer 206 is etched in a mesa shape, thereby exposing a portion of the first type semiconductor layer 202. The exposed portion of the first type semiconductor layer 202 is bonded to a portion of the electrode pattern 209 and the second type semiconductor layer 206 is bonded to the other portion of the electrode pattern 209 using wires W.

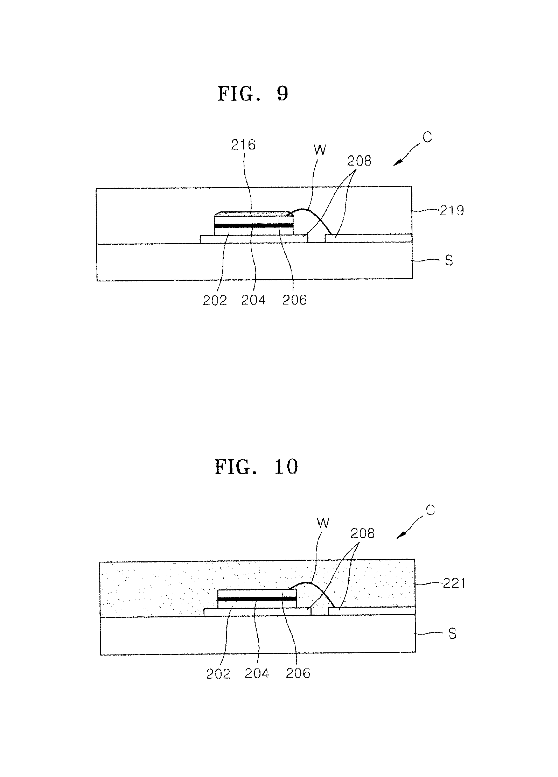

FIG. 9 is a cross-sectional view of another example of an light emitting device C that is included in the light-emitting module 130 of the LED engine 100 of FIG. 1. In the light emitting device C according to the present embodiment, the fluorescent layer 216 is applied only to a top end of the light-emitting chip. The illustrated shape of the cover layer 219 is flat. However, the shape of the cover layer 219 is not limited thereto. For example, the cover layer 219 may have a lens shape to control the direction property of light emitted from the light-emitting chip.

FIG. 10 is a cross-sectional view of another example of a light emitting device C that is included in a light-emitting module 130 of the LED engine 100 of FIG. 1. The light emitting device C according to the present embodiment is different from the light emitting device C illustrated in FIG. 10 in that instead of the application of the fluorescent layer only to the top end of the light-emitting chip, a cover layer 221 includes a mixture including a transparent material, such as resin, and a fluorescent material. The cover layer 221 may also have a lens shape to control the direction property of light emitted from the light-emitting chip.

As described above, the light emitting devices exemplarily described with reference to FIGS. 7 to 10 are disposed individually packaged on the substrate S and wire-bonded to an electrode pattern formed on the substrate S. Also, according to the shape of an electrode pattern formed on the substrate S, adjacent light emitting devices C may be connected in series, parallel, or a combination thereof.

Also, the respective light emitting devices C of the light-emitting module 130 may be connected by not a wire but a connection portion such as a metal layer and the whole structure forms one single package. Hereinafter, this structure will be described in detail.

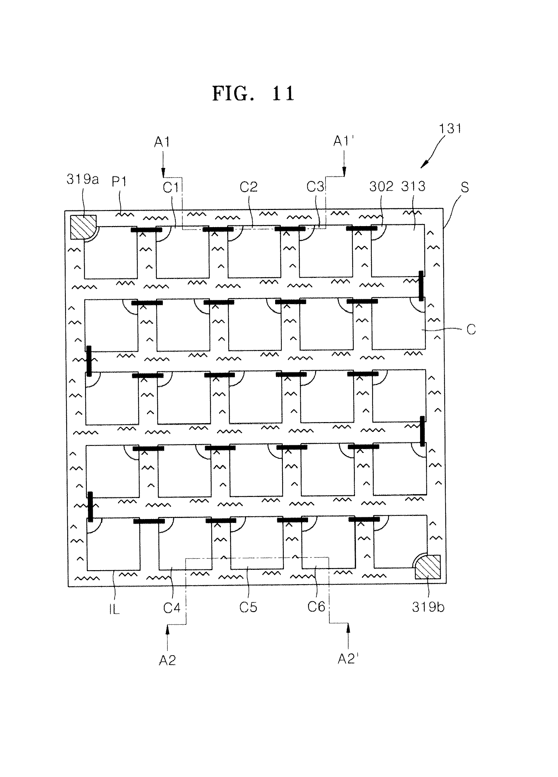

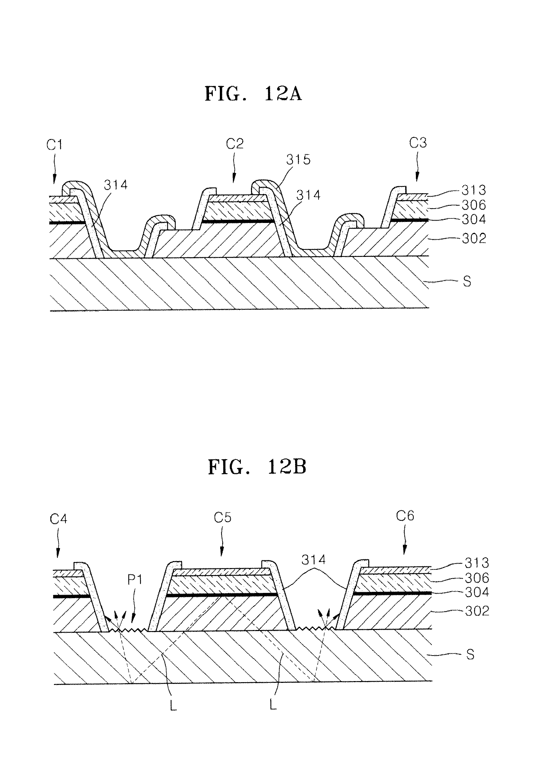

FIG. 11 is a plan view of a light-emitting module 131 as an example of the light-emitting module 130 that may be employable in the LED engine 100 of FIG. 1 and FIGS. 12A and 12B are cross-sectional views of the light-emitting module 131 of FIG. 11 taken along lines A1-A1' and A2-A2', respectively.

Referring to FIGS. 11 and 12A, the light-emitting module 131 according to the present embodiment includes a substrate S and at least one light emitting devices C arranged on an upper surface of the substrate S. The light emitting devices C may be obtained by dividing a semiconductor multi-layer including a first type semiconductor layer 302, an active layer 304, and a second type semiconductor layer 306 sequentially formed on the upper surface of the substrate S through an isolation process. Alternatively, the plurality of light emitting devices C are each individually formed from the growth process.

As illustrated in FIGS. 11, 12A, and 12B, adjacent light emitting devices C may be connected to each other by a connection portion 315. That is, the connection portion 315 may be a metal layer applied on a portion of each of the light emitting devices C, a portion of the substrate S, and a portion of a corresponding adjacent light emitting device C. In detail, each of the light emitting devices C has an exposed portion of the first type semiconductor layer 302 formed by mesa etching and the connection portion 315 is a metal layer applied on the exposed portion of the first type semiconductor layer 302, a portion of the substrate S, and a portion of the second type semiconductor layer 306 of a corresponding adjacent light emitting devices C.

In the illustrated example, the light emitting devices C are connected in series and first and second coupling pads 319a and 319b may be formed at light emitting devices disposed on opposite ends of the series-connection and connected to electrodes having corresponding polarities.

A transparent electrode 313 may be formed on a top surface of the second type semiconductor layer 306 and the transparent electrode 313 may be formed of a transparent conductive material, such as ITO or ZnO and may perform an ohmic contact and current dispersion. Also, an insulating layer 314 may be formed on a side of each of the light emitting devices C to prevent connection of the connection portion 315 with an undesired region. The insulating layer 314 may be formed of a material that is known in the art, such as silicon oxide or silicon nitride. The insulating layer 314 may be, as illustrated, used as a passivation layer on almost the whole side surfaces of the each of the light emitting devices C.

As in the present embodiment, due to the non-use of a wire for electrical connection between light emitting devices C, the possibility of a short circuit may be reduced and the ease of an interconnection process may be increased.

Also, an uneven structure P1 may be further formed on a portion of the substrate S on which the connection portion 315 is not formed. The uneven structure P1 effectively directs light L that is trapped in the substrate S or is consumed by emission through a side surface of the substrate S to progress upward as an effective emission direction.

The uneven structure P1 according to the present embodiment may be formed by wet etching or dry etching, or known lithography etching. Although the illustrated uneven structure P1 is formed only on a region where the connection portion 315 is not formed, if necessary, the uneven structure may also be formed on a region where the connection portion 315 is formed. For example, a substrate S having a whole uneven top surface may be used. Also, the uneven structure P1 may be provided to a lower surface of the substrate S to improve light extraction efficiency.

In the present embodiment, the light emitting devices C are connected in series. However, the connection structure is just an example, and for example, the light emitting devices C may instead be connected in parallel or a combination of series and parallel. Also, although not illustrated, a cover layer may be further used to protect the light emitting devices C and the cover layer may have a lens shape to control the direction property of progressing light. Also, to change the color of emitted light, a fluorescent layer may be further used or the cover layer may be formed of a material including a fluorescent material.

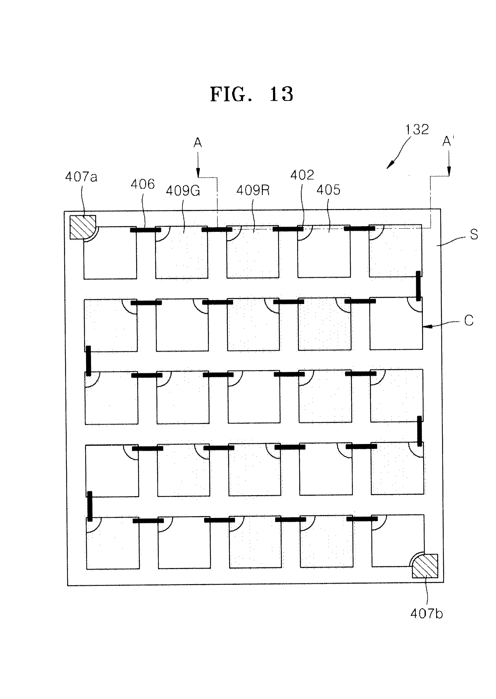

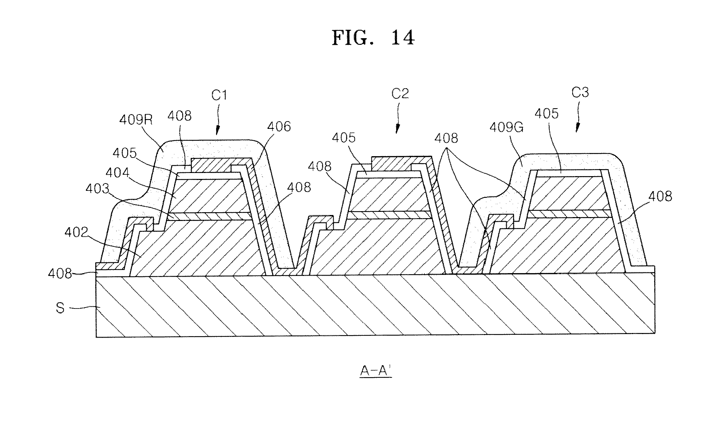

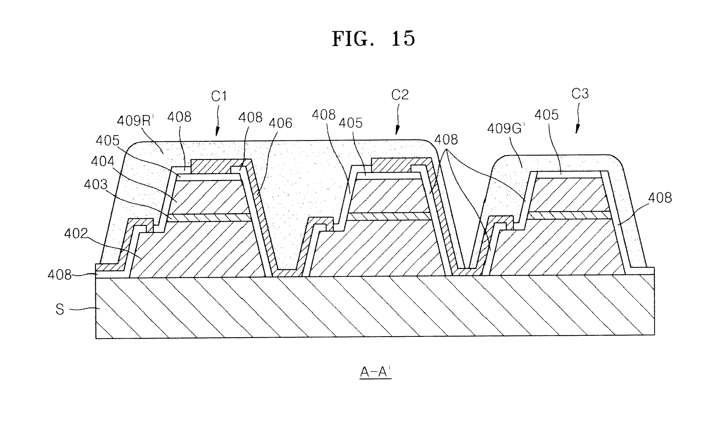

FIG. 13 is a plan view of a light-emitting module 132 as another example of the light-emitting module 130 that may be employable in the LED engine 100 of FIG. 1, FIG. 14 is a cross-sectional view of the light-emitting module 132 of FIG. 13 taken along a line A-A' and FIG. 15 is a cross-sectional view of a modified example of the light-emitting module 132 of FIG. 13.

The light-emitting module 132 includes a substrate S and a plurality of light emitting devices C arranged on an upper surface of the substrate S. The light emitting devices C may be obtained by dividing a semiconductor multi-layer including a first type semiconductor layer 402, an active layer 404, and a second type semiconductor layer 406 sequentially formed on the upper surface of the substrate S through an isolation process. Alternatively, the plurality of light emitting devices C are each individually formed from the growth process. The light emitting device C may be electrically connected to each other by a connection portion 406. Each of light emitting devices C1, C2, and C3 includes the first type semiconductor layer 402, the active layer 403, and the second type semiconductor layer 404 formed on the substrate S, and the light emitting device G1, C2, and C3 may be connected to each other in series by the connection portion 406. The connection portion 406 may be a metal layer applied on a portion of each of the light emitting device C1, C2, and C3, a portion of the substrate S, and a portion of the corresponding adjacent light emitting device. In detail, each of the light emitting device C1, C2, and C3 has an exposed portion of the first type semiconductor layer 402 that is formed by mesa etching, and the connection portion 406 may be a metal layer applied on the exposed portion of the first type semiconductor layer 402, a portion of the substrate S, and a portion of the second type semiconductor layer 404 of a corresponding adjacent light emitting device.

A transparent electrode 405 formed of, for example, a transparent conductive oxide may be disposed on the second type semiconductor layer 404 and may perform ohmic contact and current dispersion. Also, an insulating layer 408 may be interposed between the LEDs C1, C2, and C3 and the connection portion 406 to prevent an unintended short-circuiting.

As a material for forming the substrate S, an electrically insulating material may be used. Also, a conductive substrate may instead be used, and in this case, an insulating layer may be deposited thereon.

In the present embodiment, the active layer 403 of each of the light emitting devices C emits blue light, for example, light having a wavelength band of about 430 nm to about 480 nm. Also, the light emitting devices C may include the light emitting device C1 including a red light conversion portion 409R including a red light-converting material and the light emitting device C3 including a green light conversion portion 409G including a green light-converting material.

Each of the red and green light conversion portions 409R and 409G may include at least one of a fluorescent material and a quantum dot.

The materials described with reference to FIG. 7 may be used as a red fluorescent material for use in the red light conversion portion 409R and a green fluorescent material for use in the green light conversion portion 409G.

Also, the quantum dot is a nanocrystal particle including a core and a shell, wherein the size of the core may be in a range of about 2 nm to about 100 nm. The quantum dot may be used as a fluorescent material that emits various light colors, such as blue (B), yellow (Y), green (G), or red (R), by controlling the core size. The core-shell structure that forms the quantum dot may be formed by hetero-contacting at least two semiconductors selected from the group consisting of Group II-VI compound semiconductors (ZnS, ZnSe, ZnTe, CdS, CdSe, CdTe, HgS, HgSe, HgTe, MgTe, etc.), Group III-V compound semiconductors (GaN, GaP, GaAs, GaSb, InN, InP, InAs, InSb, AlAs, AIP, AlSb, AIS, etc.), and Group IV semiconductors (Ge, Si, Pb, etc.). In this case, an organic ligand may be formed using, for example, an oleic acid, on an outer surface of the shell of the quantum dot to stop a molecular binding at the outer surface of the shell, to suppress agglomeration of quantum dots and improve dispersibility thereof in a resin, such as silicon resin or epoxy resin, or to enhance the function as a fluorescent material.

In FIG. 13, the red and green light conversion portions 409R and 409G occupy a wider region than the corresponding light emitting devices C do. However, according to a process condition or purpose, each of the red and green light conversion portions 409R and 409G may be formed on a portion of a surface of a corresponding light emitting device C, for example, only a top surface of the corresponding light emitting device C.

Also, in the present embodiment, one light emitting device C includes one of the red and green light conversion portions 409R and 409G. However, according to a process condition, two or more light emitting devices C may share one of the red and green light conversion portions 409R and 409G. Also, although in FIG. 14, the red and green light conversion portions 409R and 409G are conformed to surfaces of the corresponding light emitting devices C and have a shape similar to that of a corresponding light emitting devices C, the shapes of the red and green light conversion portions 409R and 409G are not limited thereto and may have, for example, a dome shape, not conforming to the surfaces of the corresponding light emitting devices C. In addition, as illustrated in FIG. 15, two or more light emitting devices C1 and C2 may share one light conversion portion 409R'.

In the structures described above, the blue light emitted from the light emitting devices C may be mixed with light emitted from the red and green light conversion portions 409R and 409G to form white light. The red and green light conversion portions 409R and 409G may not be both included, and according to some embodiments, only one of the red and green light conversion portions 409R and 409G may be included.

Also, because a blue light may exist that is not conversed by the red and green light conversion portions 409R and 409G and passes through the red and green light conversion portions 409R and 409G, all of the light emitting device C may include any one of the red and green light conversion portions 409R and 409G. However, to improve a color rendition index or obtain white light having a low color temperature, some of the light emitting device C (for example, C2 of FIG. 14) may not have a light conversion portion. The number or arrangement method of the red and green light conversion portions 409R and 409G may be appropriately determined by binning according to a color temperature and a color rendition index. As described above, according to the present embodiment, one device emits red, green, and blue lights and the number and arrangement method thereof are controllable according to purpose. Accordingly, an LED engine according to an embodiment of the present invention may be appropriate for use as an illumination device, such as an illumination device that realizes an emotional illumination.

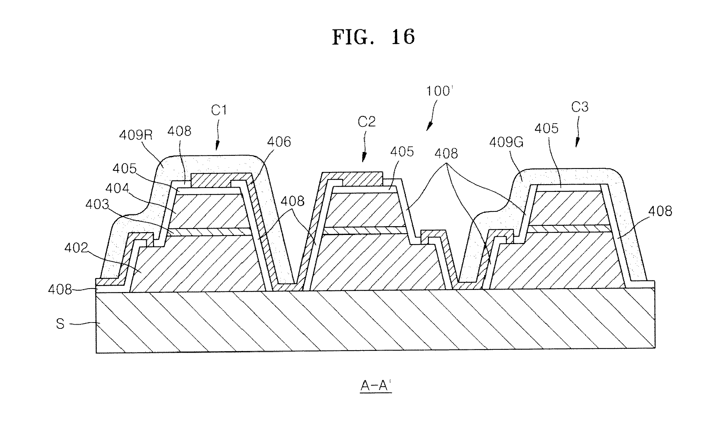

FIG. 16 is a cross-sectional view of another modified example of the light-emitting module 132 of FIG. 13. Referring to FIG. 13, light emitting devices C are electrically connected in series, and in detail, the connection between light emitting devices C is n-p connection. However, as illustrated in FIG. 16, the second type semiconductor layer 404 of the light emitting device C1 may be electrically connected to the second type semiconductor layer 404 of the light emitting device C2 and the first type semiconductor layer 402 of the light emitting device C2 may be electrically connected to the first type semiconductor layer 402 of the light emitting device C3. This connection is a connection between semiconductor layers having an identical polarity (p-p connection or n-n connection).

Other than the connection structures illustrated in FIGS. 13 to 16, a plurality of light emitting devices C may instead be connected in parallel or a combination of series and parallel.

Although not illustrated, a cover layer may be further formed to protect the light emitting devices C and the cover layer may have a lens shape to control the direction property of progressing light.

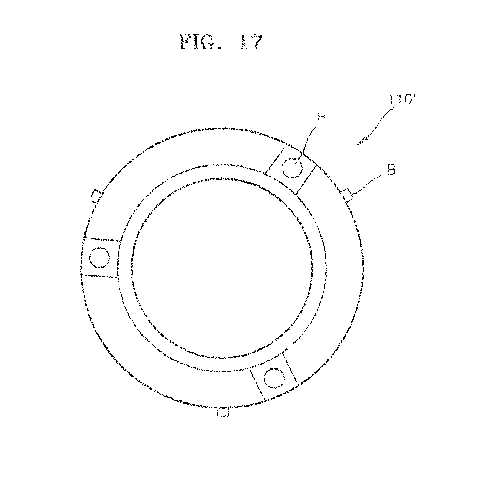

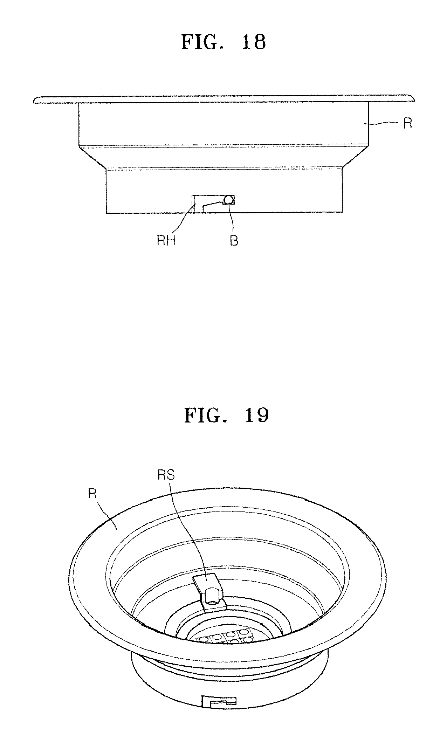

FIG. 17 is a plan view of a body 110' as a modified example of the body 110 of the LED engine 100 of FIG. 1. Referring to FIG. 18, a plurality of bosses B for coupling with an external device are formed on an outer wall of the body 110'. Also, a plurality of coupling holes H for coupling with an external device are formed in an upper surface of the body 110'. In FIG. 18, three bosses B and three coupling holes H are illustrated. However, the number of bosses and coupling holes is not limited thereto. Also, it is not necessary to include both a boss B and a coupling hole H, and only one of the boss B and the coupling hole H may be included.

FIG. 18 illustrates an example of boss coupling of the body 110' of FIG. 17 and an external device, for example, a reflector R. When an LED engine is mounted inside the reflector R, the bosses B formed on the outer wall of the body 110' may be inserted into, for example, a crooked hole RH formed in the reflector R, and thus the LED engine is fixedly coupled to the reflector R.

FIG. 19 illustrates an example of screw coupling of the body 110' of FIG. 17 and an external device, for example, a reflector R. The LED engine may be fixedly coupled to the reflector R by inserting a screw RS into a hole formed in the body 110' inside the reflector R.

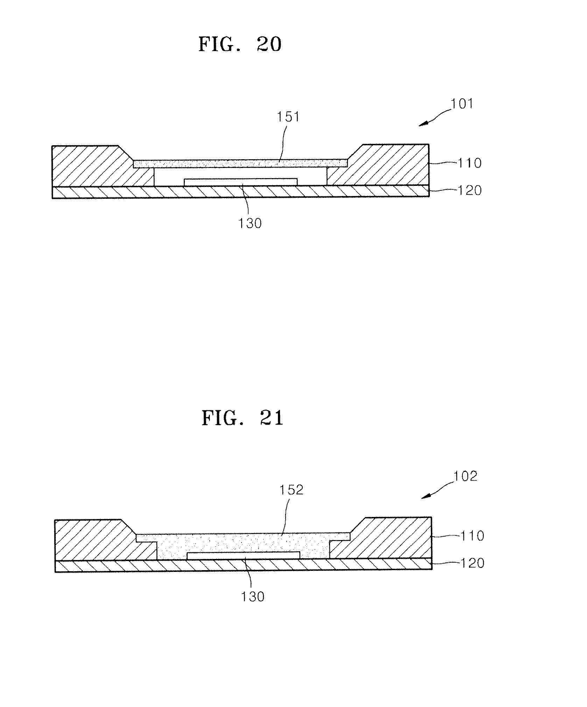

FIG. 20 is a schematic cross-sectional view of an LED engine 101 according to another embodiment of the present invention. The LED engine 101 according to the present embodiment is different from the LED engine 100 of FIG. 5 in that a sheet-shaped diffusion unit 152 is formed of a material mixed with a fluorescent material. That is, the diffusion unit 152 may include a mixture including a transparent material, for example, a resin material, and a diffusing material and a fluorescent material. Color change may be induced by a fluorescent layer coated on a light emitting device that forms the light-emitting module 130, and also color change or clarity may also be controllable by a fluorescent material included in the diffusion unit 152. In this embodiment, the LED that forms the light-emitting module 130 may not include the fluorescent layer. In FIG. 21, the upper surface of the diffusion unit 152 is flat. However, the upper surface shape is just an example. For example, the diffusion unit 152 may have a dome shape or any other shape in consideration of light distribution.

FIG. 21 is a schematic cross-sectional view of an LED engine 102 according to another embodiment of the present invention. The LED engine 102 according to the present embodiment is different from the LED engine 100 of FIG. 5 or the LED engine101 of FIG. 20 in that the diffusion unit 152 is not separated from the light-emitting module 130 and completely covers the light-emitting module 130. The diffusion unit 152 may include a mixture including a transparent material, for example, a resin material, and a diffusing material, or a fluorescent material may be further mixed with the mixture.

The LED engines 101 and 102 described with reference to FIGS. 20 and 21, respectively, may include the light emitting devices C having various structures and the light-emitting modules 131 and 132 described with reference to FIGS. 7 to 16, and the body 110 may also be modified like the body 110' of FIG. 17. Also, the light distribution controller 140 of FIG. 6 may be further included.

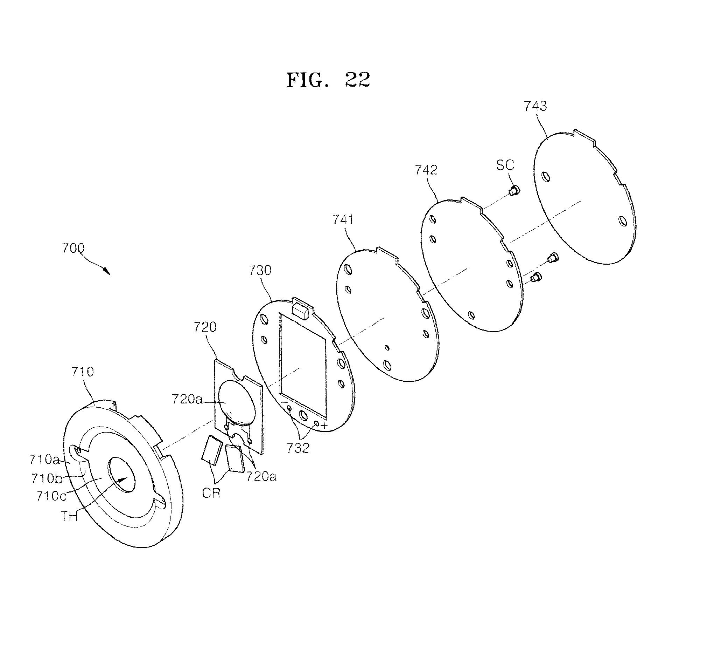

FIG. 22 is an exploded schematic view of an LED engine 700 according to another embodiment of the present invention.

Referring to FIG. 22, the LED engine 700 includes a body 710 having a through-hole TH, a light-emitting module 720 that is disposed under the body 710, and a PCB 730 which is disposed under the body 710 and to which the light-emitting module 720 is coupled.

The through-hole TH of the body 710 may have, as illustrated, a circular cross-sectional shape having a predetermined diameter. However, the shape of the through-hole TH may not be limited thereto.

The body 710 may have a flat surface 710c that enters in a direction from a top surface 710a of the body 710 to the through-hole TH and surrounds the through-hole TH. As illustrated, the top surface 710a and the flat surface 710c may be connected via a slanted surface 710b.

The light-emitting module 720 may include one or more light emitting devices (not shown), and a light-emitting surface 720a which is formed by the light emitting devices may be disposed to be exposed by the through-hole TH.

The PCB 730 may include a terminal unit 732 for supplying power to the light-emitting module 720, and via a conductive rubber CR, the light-emitting module 720 may be electrically connected to the PCB 730 each other. As illustrated, an electrode pad 722 of the light-emitting module 720 may be electrically connected to the terminal unit 732 of the PCB 730 via the conductive rubber CR.

One or more thermal conductive pads 741, 742, and 743 may be disposed under the PCB 73. The thermal conductive pads 741, 742, and 743 may be of, for example, aluminum plates with good thermal conductivity and the number of the thermal conductive pads not limited thereto.

The thermal conductive pads 741, 742, and 743 may be coupled to a lower of the body 710 with the PCB 730 via a screw (SC). This coupling, is for illustrative purpose only, and as in FIG. 4, a protrusion be on the bottom surface of the body 710 and the thermal conductive pads 741, 742, and 743 are press-in coupled thereto.

A of the through-hole TH of the body 710 be appropriately determined according to a of the light-emitting surface 720a formed by the light-emitting module 720. The light-emitting module 720 the PCB 730 are designed to be appropriate for brightness and power required by an illumination device to which the LED engine 700 is employed, and the size of the through-hole TH may be determined in such a way that a diameter of the light-emitting surface 720a formed by the light-emitting module 720 is equal to or smaller than a diameter of the through-hole TH. For example, the LED engine 700 may be designed for use in a 13W socket and in this case, the diameter of the light-emitting surface 720a may be in a range of about 9 mm to about 13.5 mm.

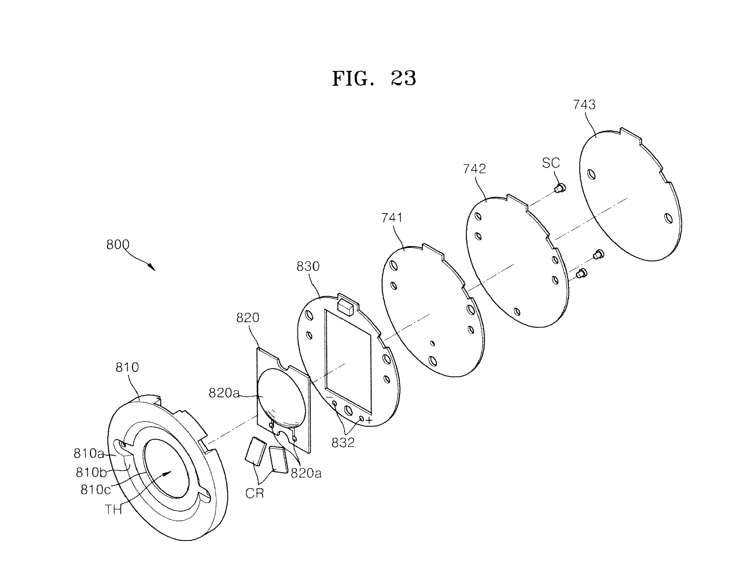

FIG. 23 is an exploded schematic view of an LED engine 800 according to another embodiment of the present invention.

The LED engine 800 according to the present embodiment induces a body 810, a light-emitting module 820, and a PCB 830, and detailed structures of the body 810, light-emitting module 820, and PCB 830 are different from corresponding elements of the LED engine 700, The LED engine 800 may have the same external size as that of the LED engine 700 of FIG. 22, and according to brightness and power required by an illumination device to which the LED engine 800 is employed, structures of the light-emitting module 820 and the PCB 830 may be changed. The light-emitting module 820 may form a light-emitting surface 820a having a size that is different from that of LED engine 700 of FIG. 22, and accordingly, the through-hole TH of the body 810 may have a corresponding size. For example, the LED engine 800 may be designed for use in a 26W and a diameter of the light-emitting surface 820a may be in a range of about 13.5 mm to 19 mm.

As a light emitting device that is employable in the light-emitting modules 720 and 820 of the LED engines 700 and 800 of FIGS. 22 and 23, the light emitting devices (C) explained with reference to FIGS. 7 to 10 may be used. In this regard, a series or parallel structure of the light emitting devices (C) may be employed. According to another embodiment of the present invention, as illustrated in FIGS. 11 to 16, light emitting devices (C) may be connected to each other by a connection unit of a metal layer form, not a wire, and the whole connected structure may be employed as one package.

Also, the LED engines 700 and 800 of FIGS. 22 and 23 may each further include the diffusion unit 150 explained with reference to FIG. 2 or the light distribution controller 140 explained with reference to FIG. 6.

The LED engines may be used in an illumination device for local illumination.

The LED engine may employ a diffusion unit and in this case, an artifact interference phenomenon is suppressed and light with smooth distribution may be emitted.

Also, in a light-emitting module included in the LED engine, a plurality of light emitting devices are connected wirelessly, thereby reducing a level of process complication and wire defects and providing light with high efficiency and high rendition index.

Also, a body presented herein is easily coupled or replaced in an illumination set.

It should be understood that the exemplary embodiments described therein to help understand an LED engine for illuminations should be considered in a descriptive sense only and not for purposes of limitation. Descriptions of features or aspects within each embodiment should typically be considered as available for other similar features or aspects in other embodiments.

## Claims

1. A light-emitting device (LED) engine comprising:
a body having a through-hole;
a light-emitting module that is disposed under the body, comprises at least one light emitting device , and is disposed to expose a light-emitting surface via the through-hole; and
a printed circuit board (PCB) which is disposed under the body, to which the light-emitting module is coupled, and comprises a terminal unit for supplying power to the light-emitting module.

2. The LED engine of claim 1, wherein the through-hole is formed in a central portion of the body and has a circular cross-sectional shape having a predetermined diameter.

3. The LED engine of claim 1, wherein the light-emitting module is electrically connected to the terminal unit via a conductive rubber.

4. The LED engine of claim 1, wherein at least one thermal conductive pad is disposed under the PCB.

5. The LED engine of any preceding claim, further comprising a light distribution controller that is disposed above the light-emitting module and comprises at least one lens portion respectively corresponding to the at least one light emitting device of the light-emitting module.

6. The LED engine of any preceding claim, further comprising a diffusion unit that is disposed above the light-emitting module and mixes light emitted from the light-emitting module.

7. The LED engine of claim 6, wherein the body has a flat surface that enters in a direction from a top surface of the body to the through-hole and surrounds the through-hole, and
the diffusion unit is formed as a diffusion sheet, which is spaced apart from the light-emitting module by a predetermined distance and is placed on the flat surface.

8. The LED engine of claim 7, wherein at least one surface of the diffusion sheet has a micro pattern.

9. The LED engine of claim 6, wherein the diffusion unit comprises a diffusing material and a resin material filled with a fluorescent material.

10. The LED engine of any preceding claim, wherein a plurality of protruding portions are formed on a lower surface of the body and
a plurality of holes are formed in the PCB, respectively corresponding to the protruding portions,
wherein the body is press-in coupled to the PCB substrate.

11. The LED engine of any preceding claim, further comprising a plurality of bosses on an outer wall of the body for coupling with an external device, or
further comprising a plurality of coupling holes in an upper surface of the body for coupling with an external device.

12. The LED engine of any preceding claim, wherein the light-emitting module comprises
a substrate and the at least one light emitting device disposed on the substrate,
and
a connection portion for connecting the at least one light emitting device in series, parallel, or a combination thereof,
wherein the connection portion is formed as a metal layer covering a portion of each of the light emitting devices, a portion of the substrate, and a portion of a corresponding adjacent light emitting device.

13. The LED engine of claim 12, wherein an uneven structure is formed on a portion of the substrate on which the metal layer is not formed and/or on a lower surface of the substrate, and
wherein the uneven structure has an indented portion having a slanted side surface.

14. The LED engine of any preceding claim, wherein the light-emitting module comprises
a substrate and a plurality of light emitting devices disposed on the substrate,
and
a connection portion that connects the plurality of light emitting devices in series, parallel, or a combination thereof and is formed as a metal layer covering a portion of each of the plurality of light emitting devices, a portion of the substrate, and a portion of a corresponding adjacent light emitting device,
wherein each of the light emitting devices comprises an active layer that emits blue light, and
the plurality of light emitting devices comprise a light emitting device including a red light conversion portion having a red light-converting material and a light emitting device including a green light conversion portion having a green light-converting material.

15. The LED engine of claim 14, wherein some of the plurality of light emitting devices comprises a light emitting device that do not include neither the green light conversion portion nor the red light conversion portion, and
wherein the green light conversion portion or the red light conversion portion is shared by two or more adjacent light emitting devices.
